# EUROPÄISCHE PATENTSCHRIFT

(11) **EP 1 783 831 B1**
(45) Veröffentlichungstag und Bekanntmachung des Hinweises auf die Patenterteilung: **25.08.2010**
(21) Anmeldenummer: 06022571.1
(22) Anmeldetag: 28.10.2006
(51) Int. Cl.: H01L 21/683, H01L 21/673

(54) **Anordnung mit Leistungshalbleitermodulen und mit Vorrichtung zu deren Positionierung sowie Verfahren zur Oberflächenbehandlung der Leistungshalbleitermodule**
Assembly of power semiconductor modules and device for positioning and method for surface treatment of said power semiconductor modules
Ensemble de modules semi-conducteurs de puissance et dispositif de positionnement et méthode de traitement de surface de lesdits modules semiconducteur de puissance

(30) Priorität: 05.11.2005 DE 102005052798
(43) Veröffentlichungstag der Anmeldung: 09.05.2007
(73) Patentinhaber: Semikron Elektronik GmbH & Co. KG Patentabteilung, 90431 Nürnberg (DE)
(72) Erfinder: Jost, Jakob, 90579 Langenzenn (DE)

(56) Entgegenhaltungen:
- EP-A- 0 932 193
- EP-A- 1 544 130
- WO-A-85/04385
- US-A- 3 868 759
- US-A- 4 915 565
- US-A1- 2005 072 972

## Beschreibung

Die Erfindung beschreibt eine Anordnung mit einer Mehrzahl von Leistungshalbeitermodulen und mit einer Vorrichtung zur zueinander beabstandeten Positionierung dieser nach Anspruch 1 sowie ein Verfahren zur Oberflächenbehandlung der positionierten Leistungshalbleitermodule nach Anspruch 2. Einen Ausgangspunkt der Erfindung bilden Leistungshalbleitermodule wie sie beispielhaft aus der DE 196 30 173 A1 bekannt und beispielhaft mittels der DE 103 58 843 A1 zueinander beabstandet angeordnet sind.

Die Erfindung geht exemplarisch aus von einer Mehrzahl von Leistungshalbleitermodulen gemäß der DE 196 30 173 A1 die in einer Transportverpackung gemäß der DE 103 58 843 A1 angeordnet sind. Vor dem Transport soll beispielhaft eine Wärme leitende Schicht auf das Substrat der Leistungshalbleitermodule aufgebracht werden, damit die Leistungshalbleitermodule nach dem Transport sofort ohne weitere Oberflächenbehandlung in eine Schaltungsanordnung beispielhaft einen Stromrichter eingebaut werden können.

Die genannten Leistungshalbleitermodule weisen zwei Hauptflächen auf, wobei auf einer zweiten die Kontaktelemente zur elektrischen Kontaktierung angeordnet sind. Die erste Hauptfläche wird gebildet durch ein Substrat. Dieses Substrat trägt auf der dem Inneren des Leistungshalbleitermoduls zugewandten Seite Leistungshalbleiterbauelemente und dient auf der dem Inneren des Leistungshalbleitermoduls abgewandten Seite der thermisch leitenden Verbindung zu einem Kühlbauteil. Diese thermisch leitende Verbindung zwischen dem Substrat und den Kühlbauteil wird gemäß dem Stand der Technik durch eine Zwischenschicht aus einer Wärme leitenden Schicht, einer sog. Wärmeleitpaste, gebildet.

Diese Wärmeleitpaste muss als homogene Schicht oder als homogene Verteilung von einzelnen Schichtelementen ausgebildet sein, um einen effizienten Wärmeübergang nach der Montage des Leistungshalbleitermoduls auf dem Kühlkörper zu gewährleisten. Derartige Schichten aus Wärmeleitpaste weisen allerdings den Nachteil auf als pastöse Schicht empfindlich gegen eine Verletzung der Homogenität zu sein. Aus diesem Grund wird gemäß dem Stand der Technik die Wärmeleitpaste vorzugsweise unmittelbar vor der Anordnung des Leistungshalbleitermoduls auf dem Kühlkörper aufgetragen. Da diese Schicht allerdings eine möglichst hohe Homogenität, also eine gleichmäßige Schichtdicke, aufweisen muss sind hierfür beispielhaft Siebdruckverfahren geeignet, die am Ort der Montage nicht zwangsläufig zur Verfügung stehen.

Transportverpackungen für o.g. Leistungshalbleitermodule sind in der DE 103 58 843 A1 offenbart. Derartige Transportverpackungen ordnen eine Mehrzahl von Leistungshalbleitermodulen in einem bis auf einige Millimeter Toleranz definiertem Abstand zueinander an. Weiterhin sind diese Verpackungen derart ausgestaltet, dass die beiden Hauptflächen des jeweiligen Leistungshalbleitermoduls nicht oder nur zu einem geringen aber definierten Teil mit der Transportverpackung in Berührung kommen.

Der Erfindung liegt die Aufgabe zugrunde eine Anordnung mit einer Mehrzahl von Leistungshalbleitermodulen und mit einer Vorrichtung zur voneinander beabstandeten Positionierung dieser, mit einer Toleranz von weniger als einem Millimeter, zueinander vorzustellen sowie ein zugehöriges Verfahren zur gleichzeitigen Oberflächenbehandlung dieser Mehrzahl von Leistungshalbleitermodulen vorzustellen.

Die Aufgabe wird erfindungsgemäß gelöst, durch die Maßnahmen der Merkmale der Ansprüche 1 und 2. Bevorzugte Ausführungsformen sind in den Unteransprüchen beschrieben.

Der erfinderische Gedanke geht aus von einer Mehrzahl von Leistungshalbleitermodulen, die in einem nicht exakt definierten Raster lateral zueinander angeordnet sind, und deren horizontale Lage zueinander ebenfalls definiert ist. Die Erfindung beschreibt eine Anordnung mit einer Vorrichtung zur Aufnahme und Positionierung dieser Mehrzahl voneinander beabstandeter Leistungshalbleitermodule. Hierzu wird ein Positionierformkörper vorgeschlagen, der eine plane erste Hauptfläche und eine Mehrzahl von Ausnehmungen zur Aufnahme der Leistungshalbleitermodule aufweist.

Jeder der genannten Ausnehmung weist in Richtung der Normalen der ersten Hauptfläche ein Anschlagmittel auf, wodurch jeweils eine Hauptfläche eines Leistungshalbleitermoduls planparallel und fluchtend zu dieser ersten Hauptfläche des Positionierformkörpers positioniert wird. Weiterhin weisen die Ausnehmungen ausgehend von der zweiten Hauptfläche des Positionierformkörpers in Richtung seiner ersten Hauptfläche zumindest in einem Teilabschnitt eine konisch zulaufende Ausgestaltung auf.

Das zugehörige Verfahren zur gleichzeitigen Oberflächenbehandlung einer Mehrzahl von Leistungshalbleitermodule nutzt die o.g. Vorrichtung zur Ausrichtung und Fixierung der Leistungshalbleitermodule in ihrer Lage und wendet dann das entsprechend geeignete Beschichtungsverfahren zur vollflächigen oder abschnittsweise Beschichtung der ersten Hauptflächen der Leistungshalbleitermodule mit einem Werkstoff an.

[10a] Weiterhin bekannt ist aus der US 2005/072972 A1 eine Schutzeinrichtung beispielhaft für den Transport eines Halbleiterbauelemets, wobei dieses Halbleiterbauelement eine Multichipanordnung von integrierten Schaltungen ist. Aus der US 3,868,759 ist eine Anordnung zur Vorausrichtung eines ungehausten Halbleiterchips zur Bondverbindung dieses Halbleiterchips mit einem Leadframe. Ebenso ist aus der US 4,915,565 eine Vorrichtung zur Bewegung eines Carriers mit integrierten Schaltkreises bekannt wobei die einzelnen Chips vom Carrier abgenommen und schaltungsgerecht angeordnet werden.

[10b] Weiterhin ist aus der EP 0 932 193 A2 eine Methode bekannt um sog. Solderbumps oder bump electrodes in einem Arbeitsschritt auf einer Waferoberfläche anzuordnen.

Die erfinderische Lösung wird an Hand der Ausführungsbeispiele der Fig. 1 bis 3 weiter erläutert.

Fig. 1 zeigt einen Ausschnitt des Positionierformkörpers der erfindungsgemäßen Anordnung.

Fig. 2 zeigt einen Schnitt durch den Positionierformkörper der erfindungsgemäßen Anorndung in verschieden Stadien der Positionierung von Leistungshalbleitermodulen.

Fig. 3 zeigt eine dreidimensionale Darstellung eines Ausschnitts des Positionierformkörpers der erfindungsgemäßen Anordnung.

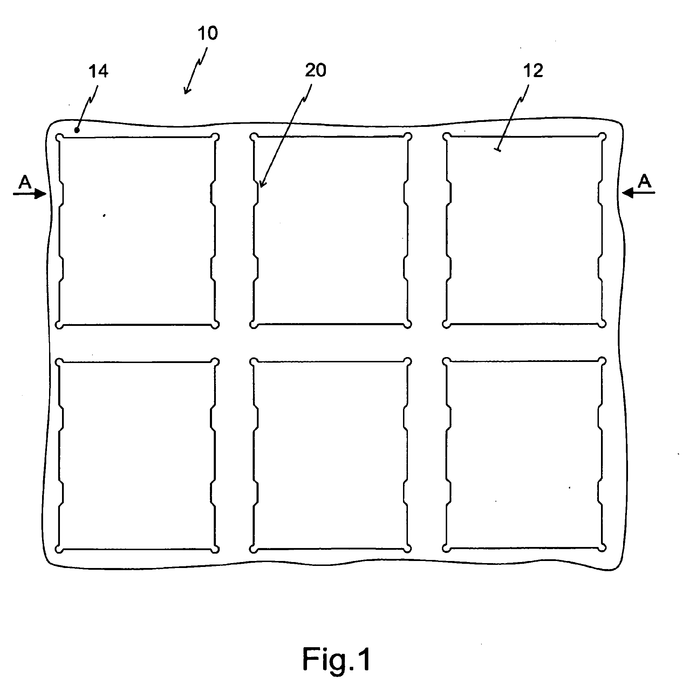

Fig. 1 zeigt einen Ausschnitt des Positionierformkörpers (10) der erfindungsgemäßen Anorndung in Draufsicht auf dessen erste Hauptfläche (14). Der Positionierformkörper (10) besteht vorzugsweise aus Aluminium mit einer planen ersten Hauptfläche (14). Der Positionierformkörper (10) weist weiterhin eine Mehrzahl von Ausnehmungen (12) auf, deren laterale Abmessungen geringfügig größer sind als die entsprechenden Abmessungen eines anzuordnenden Leistungshalbleitermoduls (40). Das mittels dieses Positionierformkörpers (10) durchzuführenden Verfahren bestimmt die entsprechenden Maße. Jede Ausnehmung (12) weist ein Anschlagmittel (20) auf, das eine Verschiebung des angeordneten Leistungshalbleitermoduls (40) in Richtung der Flächennormalen der ersten Hauptfläche (14) des Positionierformkörpers (10) begrenzt. Diese Anschlagmittel (20) sind als Rastnasen ausgebildet und an zwei gegenüberliegenden Seiten der Ausnehmung (14) des Positionierformkörpers (10) angeordnet. Je nach Anforderung an die Positioniergenauigkeit können derartige Rastnasen (20) an allen Seiten, im Bedarfsfall auch mehrfach pro Seite, bevorzugt sein. Ebenfalls geeignet sind entsprechend ausgebildete Rastnasen in den Ecken der Ausnehmungen (14).

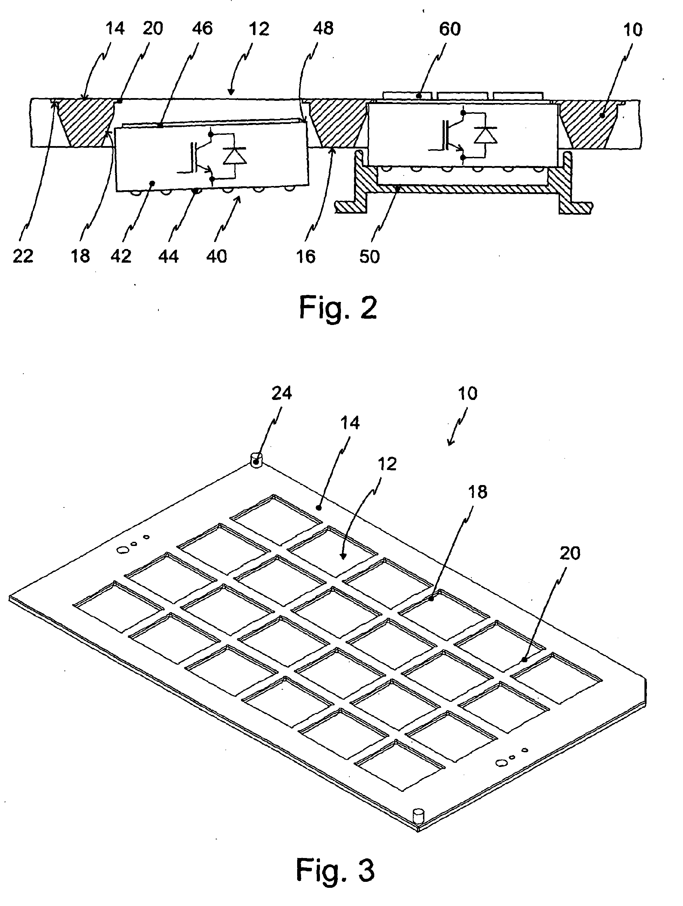

Fig. 2 zeigt einen Schnitt entlang der Linie A-A gemäß Fig. 1 durch den Positionierformkörper (10) der Vorrichtung in verschieden Stadien der Positionierung von Leistungshalbleitermodulen (40).

Der Positionierformkörper (10) weist eine erste Hauptfläche (14) auf, die als Referenzfläche für das erfindungsgemäße Verfahren dient. Weiterhin weist der Positionierformkörper (10) Ausnehmungen (12) zur Aufnahme von Leistungshalbleitermodulen (40) auf. Diese Ausnehmungen (12) weisen eine laterale Ausdehnung auf, die geringfügig größer ist als die laterale Ausdehnung des Gehäuses (42) des zugeordneten Leistungshalbleitermoduls (40). Die laterale Ausdehnung der Ausnehmung (12) ist an der zweiten Hauptfläche (16) deutlich größer als die Gehäuseabmessungen (42) des Leistungshalbleitermoduls (40). Ausgehend von dieser zweiten Hauptfläche (16) verjüngt sich die Ausnehmung (12) in Richtung der ersten Hauptfläche (14) zumindest in einem Teilabschnitt (18) konisch. Diese Ausgestaltung ist bevorzugt, da die Leistungshalbleitermodule (40) vor der Anordnung in dem Positionierformkörper (10) zwar in einem Raster, beispielhaft in einem Teil einer Transportverpackung (50), zueinander lateral angeordnet sind, allerdings hierbei die Toleranzen dieser Lage größer sind als die Toleranzen im Positionierformkörper (10).

Das anzuordnende Leistungshalbleitermodul (40) selbst weist ein Gehäuse (42) auf, das ein Substrat (46) umschließt, wodurch das Substrat (42) die erste Hauptfläche des Leistungshalbleitermoduls (40) bildet und in lateraler Richtung vom Gehäuse (42) geringfügig überragt wird. In Richtung der Flächennormale dieser ersten Hauptfläche überragt das Substrat (46) das Gehäuse (42) des Leistungshalbleitermoduls (40). Auf der zweiten Hauptfläche des Leistungshalbleitermoduls (40) sind die elektrischen Anschlusselemente (44) angeordnet.

Jede Ausnehmung (12) weist mindestens zwei, vorzugsweise gegenüber liegend angeordnete, Anschlagmittel (20) auf. Diese Anschlagmittel (20) sind vorzugsweise als Rastnasen ausgebildet, wobei diese Rastnasen die erste Hauptfläche (14) des Positionierformkörpers (10) in Richtung seiner Flächennormalen nicht überragen. Die Rastnasen (20) dienen der Begrenzung der Bewegung des Leistungshalbleitermoduls (40) in Richtung der Flächenormalen der ersten Hauptfläche (14) des Positionierformkörpers (10). Hierzu liegt das Leistungshalbleitermodul (40) mit seinen das Substrat (46) lateral überragenden Gehäuseteil (42), das somit die Anschlagkante (48) ausbildet, an den Rastflächen (22) der Rastnasen (20) an. Das Substrat (46) erstreckt sich hierbei an den Rastnasen (20) vorbei und bildet mit der ersten Hauptfläche (14) des Positionierformkörpers (10) eine planparallel und fluchtende Fläche aus.

Durch die beschriebene Vorrichtung, mit einem Positionierformkörper (10) und mit einem Teilkörper (50) einer Verpackung mit darin angeordneten Leistungshalbleitermodulen (40), werden die einzelnen Leistungshalbleitermodule (40) zueinander mit einer lateralen Lagetoleranz von 1 mm oder geringer und einer Höhentoleranz zwischen der planen ersten Hauptfläche (14) des Positionierformkörpers (10) und den jeweiligen durch das jeweilige Substrat (46) gebildeten Hauptflächen der Leistungshalbleitermodule (40) von weniger als 0,5mm zueinander ausgerichtet.

Das erfindungsgemäße Verfahren zur gleichzeitigen Oberflächenbehandlung der Substrate einer Mehrzahl von Leistungshalbleitermodulen (40) geht hier beispielhaft aus von der Anordnung der Leistungshalbleitermodule (40) in einem Teilkörper (50) einer Verpackung mit geringer lateraler Positioniergenauigkeit. Mittels des Positionierformkörpers (10) der in Richtung der Flächennormalen seiner zweiten Hauptfläche über die Leistungshalbleitermodule (40) positioniert wird, werden diese lateral bis auf die notwendigen Toleranzen zueinander ausgerichtet. Durch diese erfindungsgemäße Vorrichtung sind die Leistungshalbleitermodule (40) in ihrer Lage positioniert.

In einem weiteren Schritt können nun die ersten Hauptflächen der Leistungshalbleitermodule (40) beschichtet werden. Diese Beschichtung erfolg entweder vollflächig, wobei das gesamte Substrat (44) mit einer Schicht homogener Dicke überzogen wird, oder auch abschnittsweise, wobei beispielhaft gleiche Inseln (60) mit gleichem Abstand zueinander auf dem jeweiligen Substrat (44) der Leistungshalbleitermodule (40) aufgebracht werden.

Mittels des genannten Verfahrens können vorzugsweise Wärmeleitpasten und Klebstoffe oder auch andere Werkstoff auf die Substrate (44) aufgebracht werden. Besonders bevorzugte Verfahren hierfür sind bekannte Sieb- oder Schablonendruckverfahren.

Fig. 3 zeigt eine dreidimensionale Darstellung eines Positionierformkörpers (10) der erfindungsgemäßen Anordnung. Hierbei ist die Ausgestaltung der Anschlagmittel (20) in Form von Rastnasen, sowie der konische Verlauf (18) der Ausnehmungen (12) besonders deutlich. Weiterhin weist der Positionierformkörper (10) mindestens zwei, vorzugsweise an gegenüberliegenden Ecken angeordnete Zapfen (24), die als Positioniereinrichtung dienen, auf. Der Rahmen eines nicht dargestellten Siebes weist entsprechende Ausnehmungen auf. Die Zapfen (24) des Positionierformkörpers finden Aufnahme in den zugeordneten Ausnehmungen und positionieren somit während des Siebdruckprozesses das Drucksieb relativ zu den zu bedruckenden Leistungshalbleitermodulen (40).

## Patentansprüche

1. Anordnung mit einer Mehrzahl von Leistungshalbleitermodulen (40) in einer Vorrichtung zur Aufnahme und Positionierung dieser voneinander beabstandeten Leistungshalbleitermodule (40) mit einem Positionierformkörper (10), wobei der Positionierformkörper (10) eine plane erste Hauptfläche (14) und eine Mehrzahl von Ausnehmungen (12) zur Aufnahme der Leistungshalbleitermodule (40) aufweist,
wobei jede Ausnehmung (12) ein Anschlagmittel (20) aufweist, wodurch jeweils eine Hauptfläche eines Leistungshalbleitermoduls (40) planparallel und fluchtend zur ersten Hauptfläche (14) des Positionierformkörpers (10) positioniert ist, und
die jeweilige Ausnehmung (12) ausgehend von der zweiten Hauptfläche (16) des Positionierformörpers (10) in Richtung seiner ersten Hauptfläche (14) zumindest in einem Teilabschnitt (18) konisch zulaufend ausgebildet ist **dadurch gekennzeichnet dass** das Anschlagmittel (20) als mindestens zwei Nasen, die die erste Hauptfläche (14) des Positionierformkörpers (10) nicht überragen und im Inneren der Ausnehmungen (12) angeordnet sind ausgebildet ist und an zugeordneten Anschlagkanten (48) der Leistungshalbleitermodule (40) anliegen.

2. Verfahren zur gleichzeitigen Oberflächenbehandlung von einer Mehrzahl von Leistungshalbleitermodulen (40), in einer Anordnung gemäß Anspruch 1 wobei durch geeignete Verfahren die ersten Hauptflächen der Leistungshalbleitermodule (40) vollflächig oder abschnittsweise mit einem Werkstoff (60) beschichtet werden.

3. Anordnung nach Anspruch 1,
wobei der Positionierformkörper (10) zu einem Teilkörper (50) einer Verpackung mit darin angeordneten Leistungshalbleitermodulen (40) angeordnet ist.

4. Anordnung nach Anspruch 1,
wobei die Anschlagkanten (48) der Leistungshalbleitermodule (40) gebildet werden durch das Gehäuse (42) des jeweiligen Leistungshalbleitermoduls (40)..

5. Anordnung nach Anspruch 1,
wobei die Höhentoleranz zwischen der planen ersten Hauptfläche (14) des Positionierformkörpers (10) und den jeweiligen zugeordneten Hauptflächen der Leistungshalbleitermodule (40) geringer als 0,5mm ist.

6. Anordnung nach Anspruch 1,
wobei der Positionierformkörper (10) mindestens zwei Positioniereinrichtungen (24) für eine Siebdruckvorrichtung aufweist.

7. Verfahren nach Anspruch 2,
wobei das Beschichten mittels Sieb- oder Schablonendruck erfolgt.

8. Verfahren nach Anspruch 2,
wobei der Werkstoff (60) eine Wärmeleitpaste oder ein Klebstoff ist.

## Claims

1. An arrangement with a multiplicity of power semiconductor modules (40) of a device to accommodate and position these power semiconductor modules (40), spaced apart from one another with a shaped positioning body (10), wherein
the shaped positioning body (10) has a plane first main surface (14) and a multiplicity of recesses (12) to accommodate the power semiconductor modules (40), wherein.
each recess (12) has a stop device (20), whereby in each case a main surface of a power semiconductor module (40) is positioned plane parallel and aligned with the first main surface (14) of the shaped positioning body (10), and the respective recess (12), emanating from the second main surface (16) of the shaped positioning body (10), is designed to taper conically in the direction of its first main surface (14), at least in one section (18),
**characterised in that** the stop device (20) is designed as at least two lugs, which do not project beyond the first main surface (14) of the shaped positioning body (10) and are arranged in the interior of the recesses (12), and abut against associated stop edges (48) of the power semiconductor modules (40).

2. A method for the simultaneous surface treatment of a multiplicity of power semiconductor modules (40) in an arrangement in accordance with Claim 1, wherein
by means of suitable methods the first main surfaces of the power semiconductor modules (40) are coated over the whole surface, or in sections, with a material (60).

3. The arrangement according to Claim 1, wherein
the shaped positioning body (10) is arranged as a body part (50) of packaging with therein arranged power semiconductor modules (40).

4. The arrangement according to Claim 1, wherein
the stop edges (48) of the power semiconductor modules (40) are formed by the housing (42) of the respective power semiconductor module (40).

5. The arrangement according to Claim 1, wherein
the height tolerance between the plane first main surface (14) of the shaped positioning body (10) and the respective associated main surfaces of the power semiconductor modules (40) is less than 0.5 mm.

6. The arrangement according to Claim 1, wherein
the shaped positioning body (10) has at least two positioning devices (24) for screen printing equipment.

7. The method according to Claim 2, wherein
the coating takes place by means of screen-printing or stencil-printing.

8. The method according to Claim 2, wherein
the material (60) is a heat-conducting paste or an adhesive.

## Revendications

1. Arrangement comprenant une pluralité de modules à semi-conducteurs de puissance (40) dans un dispositif pour le logement et le positionnement de ces modules à semi-conducteurs de puissance (40) espacés les uns des autres avec un corps moulé de positionnement (10), le corps moulé de positionnement (10) présentant une première surface principale (14) plane et une pluralité d'évidements (12) pour le logement des modules à semi-conducteurs de puissance (40), chaque évidement (12) présentant un moyen de butée (20), à chaque fois une surface principale d'un module à semi-conducteurs de puissance (40) étant à faces planes et parallèles et positionnée en alignement avec la première surface principale (14) du corps moulé de positionnement (10), et l'évidement (12) respectif étant réalisé de façon conique à partir de la seconde surface principale (16) du corps de positionnement (10) en direction de sa première surface principale (14) au moins dans un tronçon partiel (18), **caractérisé en ce que** le moyen de butée (20) est réalisé sous forme d'au moins deux ergots, qui ne dépassent pas de la première surface principale (14) du corps moulé de positionnement (10) et sont disposés à l'intérieur des évidements (12) et s'appliquent sur des arêtes de butée (48) associées des modules à semi-conducteurs de puissance (40).

2. Procédé pour le traitement de surface simultané d'une pluralité de modules à semi-conducteurs de puissance (40), dans un arrangement selon la revendication 1, les premières surfaces principales des modules à semi-conducteurs de puissance (40) étant recouvertes par des procédés appropriés sur toute la surface ou par portions avec un matériau (60).

3. Arrangement selon la revendication 1,
le corps moulé de positionnement (10) étant disposé pour un former un corps partiel (50) d'un emballage avec des modules à semi-conducteurs de puissance (40) disposés à l'intérieur.

4. Arrangement selon la revendication 1,
les arêtes de butée (48) des modules à semi-conducteurs de puissance (40) étant formées par le boîtier (42) du module à semi-conducteurs de puissance (40) respectif.

5. Arrangement selon la revendication 1,
la tolérance en hauteur entre la première surface principale (14) plane du corps moulé de positionnement (10) et les surfaces principales associées respectives des modules à semi-conducteurs de puissance (40) étant inférieure à 0,5 mm.

6. Arrangement selon la revendication 1,
le corps moulé de positionnement (10) présentant au moins deux dispositifs de positionnement (24) pour un dispositif de sérigraphie.

7. Procédé selon la revendication 2,
le revêtement s'effectuant au moyen de la sérigraphie.

8. Procédé selon la revendication 2,
le matériau (60) étant une pâte thermoconductrice ou une colle.
